Europäisches Patentamt

European Patent Office

Office européen des brevets

(11) Publication number: **0 364 762**
**A1**

# EUROPEAN PATENT APPLICATION

(21) Application number: **89117517.6**

(22) Date of filing: **22.09.89**

(51) Int. Cl.⁵: **H01L 29/10 , H01L 29/60 , H01L 29/812**

(30) Priority: **24.09.88 JP 239327/88**

(43) Date of publication of application:
**25.04.90 Bulletin 90/17**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Ochi, Masanori c/o Intellectual**
**Property Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor device with optimum interlayer distance.**

(57) A semiconductor device is formed on a semi-insulating substrate (31). An operating layer (32) of one conductivity type is formed on the semi-insulating substrate (31). Low resistance layers (331, 332) of one conductivity type comprises a source layer (331) and a drain layer (332) formed on both sides of the operating layer (32). The distance between the source layer (331) and the drain layer (332) is 1.0 μm or more and less than 2.0 μm. A gate electrode (35) is formed on the operating layer (32). The distance between the gate electrode (35) and the drain layer (332) is 0.5 μm or more and less than 1.0 μm.

F I G. 1

## Semiconductor device with optimum interlayer distance

The present invention relates to semiconductor devices forming field effect transistors (FETs) and, more particularly, to semiconductor devices used as high-frequency GaAs FETs.

For example, the drift velocity of electrons in GaAs compound semiconductors is three to five times that in silicon (Si) semiconductors. For this reason, GaAs FETs, which enable a faster response, are in increasing demand.

In manufacturing a conventional GaAs FET, an operating active layer serving as a channel is first formed on a GaAs substrate by an ion implantation technique. Next, a wafer is irradiated with far ultraviolet rays through a mask to form a pattern of a low resistance layer for ohmic electrodes. The alignment at this point is carried out by bringing an alignment mark of the wafer and a mark of the mask in alignment with each other by use of an aligner. Furthermore ohmic electrodes or source and drain electrodes are formed on the low resistance layer and a gate electrode is formed on the operating layer. The semiconductor device thus formed are generally 0.5 $\mu$m or more in gate length and 2.0 $\mu$m or more in source-to-drain distance.

A problem with such a GaAs FET is the production of a surface depletion layer in the vicinity of the surface of the operating layer because surface potentials between the source and gate and between the gate and drain are fixed. This results in a narrow channel width, adversely affecting the characteristics and reliability of the FET. To solve the problem, distances between the source and gate and between the gate and drain might be reduced. In a conventional aligner, however, a distance smaller than 2.0 $\mu$m is involved within a range of errors associated with the accuracy of mask alignment, failing to obtain an accurate source-to-drain distance. Thus, the optimum source-to-drain distance cannot be determined. Also, the accuracy for gate alignment cannot be improved because of limitations of conventional step-and-repeat techniques, failing to determine the optimum gate-to-drain distance. Moreover, if the gate-to-drain distance are reduced, the withstanding voltage would be lowered.

It is accordingly an object of the present invention to provide a semiconductor device which has good operating characteristics and reliability by optimization of its distances between the source layer and the drain layer and between the gate electrode and the drain layer.

To attain the object, a semiconductor device of the present invention comprises a semi-insulating substrate; an operating layer of one conductivity type formed on the semi-insulating substrate; a low resistance layer of one conductivity type having source and drain layers formed on both sides of the operating layer of the one conductivity type, the distance between the source layer and the drain layer being 1.0 $\mu$m or more and less than 2.0 $\mu$m; and a gate electrode formed on the operating layer of the one conductivity type, the distance between the gate electrode and the drain layer being 0.5 $\mu$m or more and less than 1.0 $\mu$m.

The foregoing aspects and other features of the invention will be explained in the following description in connection with the accompanying drawing, wherein:

Fig. 1 is a cross-sectional view of a semiconductor device embodying the present invention; and

Fig. 2 is a graph illustrating characteristics of the semiconductor device of the present invention and a prior art device for comparison therebetween.

An embodiment of a semiconductor device according to the present invention, that is, a high-frequency GaAs FET will be described below with reference to the drawing.

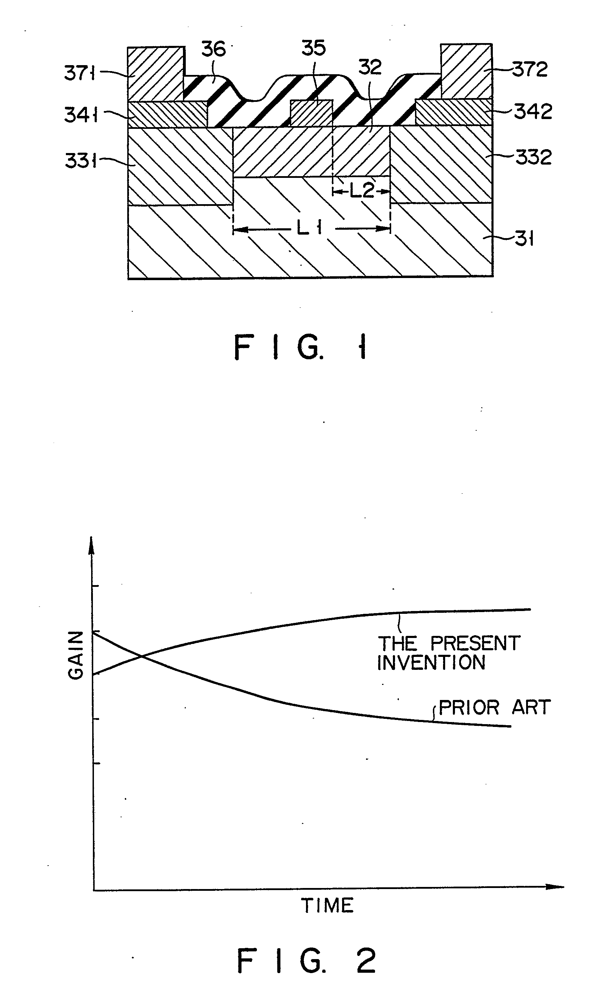

As shown in Fig. 1, a semi-insulating substrate 31 consisting of gallium arsenide (GaAs) is prepared first. Next, positive ions of silicon (Si) are introduced by an ion implanter into semi-insulating substrate 31 to form an n-type operating layer 32 serving as a channel. Low resistance layers for ohmic electrodes, that is, a source layer 331 and a drain layer 332 are then formed on substrate 31 by ion implantation of positive ions of Si, in such a way as to sandwich operating layer 32 as shown. Further, on low resistance layers 331 and 332 are respectively formed ohmic electrodes, that is, a source electrode 341 and a drain electrode 342 by deposition method by way of example. Afterward, on operating layer 32 is formed a gate electrode 35 having a length of the order of 0.5 $\mu$m and a width of the order of 300 $\mu$m. Subsequently, metal in areas other than ohmic electrodes 341 and 342 is stripped by use of lift-off method. The method of forming gate electrode 35 involves the following steps. That is, after the formation of operating layer 32, a metal layer of a three-layer structure consisting of gold (Au), platinum (Pt) and titanium (Ti) is deposited over the entire surface of the substrate, a resist mask is formed on the metal layer by EB (electron beam) direct drawing method and then metal in areas other than the gate portion is etched away by reactive ion etching (RIE) and ion milling. Afterward, a passivation film, for example, a silicon dioxide ($SiO_2$) film 36 is deposited and pad electrodes 371 and 372 are deposited on ohmic electrodes 341 and 342, respectively, thereby to form a desired high-frequency GaAs FET. The main feature of the present invention is that the distance Ll between source and drain layers 331 and 332 is 1.0 μm or more and less than 2.0 μm and the distance L2 between gate electrode 35 and drain layer 332 is 0.5 μm or more and less than 1.0 μm, preferably about 0.7 μm. This is feasible owing to an improvement in the accuracy of gate positioning resulting from the use of the EB direct drawing method and an improvement in the step-and-repeat technique.

Fig. 2 illustrates variations of gains of the semiconductor device of the present invention and a prior art semiconductor device with time after they are supplied with a bias voltage. As can be seen readily from the graph, with the prior art device, the gain reduces with time. This is due to the following reasons. Current $I_{DSS}$ flowing between the source and drain when, for example, the gate voltage is 0 volts and the voltage across the source and drain is 3 volts is reduced under the influence of the surface depletion layer and source-to-drain distance. For this reason, the mutual conductance gm between the source and drain is also reduced, thus decreasing the gain. On the other hand, in the semiconductor device of the present invention in which the distance between the source and drain layers is smaller than 2.0 μm and the distance between the gate electrode and the drain layer is in the range of 0.5 μm to 1.0 μm, the curve of gain does not fall with time as is evident from Fig. 3. In general, the smaller source to drain distance is better in achieving a large gain, while the greater mutual conductance is better. However, the greater the mutual conductance, the lower the withstand voltage. The contrary is also true. Accordingly, the above range of the source to drain distance in the semiconductor device of the present invention was determined by taking into account the relationship between the withstand voltage and the mutual conductance. This could be achieved by the recent remarkable advances in semiconductor manufacturing technology.

As described above, the semiconductor device of the present invention, which is made possible by improvements in the EB direct drawing method and the step to repeat technique, has a structure in which the distance between the source and drain layers is smaller than 2.0 μm and the distance between the gate electrode and the drain layer is 0.5 μm or more and less than 1.0 μm. Accordingly, the present invention can provide a semiconductor device which is excellent in operating characteristics and reliability.

Reference signs in the claims are intended for better understanding and shall not limit the scope.

## Claims

1. A semiconductor device comprising:
a semi-insulating substrate (31);
an operating layer (32) of one conductivity type formed on said semi-insulating substrate (31);
low resistance layers (331, 332) of one conductivity type having source and drain layers (331, 332) formed on both sides of said operating layer (32) to sandwich it therebetween; and
a gate electrode (35) formed on said operating layer (32), characterized in that the distance between said source and drain layers (331, 332) is 1.0 μm or more and less than 2.0 μm and the distance between said gate electrode (35) and said drain layer (332) is 0.5 μm or more and less than 1.0 μm.

2. A semiconductor device according to claim 1, characterized in that said semi-insulating substrate (31) is formed of gallium arsenide.

3. A semiconductor device according to claim 1, characterized in that the distance between said source layer (331) and said drain layer (332) is about 1.5 μm.

4. A semiconductor device according to claim 1, characterized in that the distance between said gate electrode (35) and said drain layer (332) is about 0.7 μm.

5. A semiconductor device according to claim 1, characterized in that said gate electrode (35) is about 0.5 μm in length and about 300 μm in width.

6. A semiconductor device according to claim 1, characterized in that said gate electrode (35) is formed by an electron beam direct drawing method.

7. A semiconductor device comprising:
a semi-insulating substrate (31);
an operating layer (32) of one conductivity type formed on said semi-insulating substrate (31);
low resistance layers (331, 332) of one conductivity type having source and drain layers (331, 332) formed on both sides of said operating layer (32) to sandwich it therebetween;
a gate electrode (35) formed on said operating layer (32);
a source electrode (341) formed on said source layer (331); and
a drain electrode (342) formed on said drain layer (332), characterized in that the distance between said source and drain layers (331, 332) is 1.0 μm or more and less than 2.0 μm and the distance between said gate electrode (35) and said drain layer (332) is 0.5 μm or more and less than 1.0 μm.

8. A semiconductor device according to claim 7, characterized in that said semi-insulating substrate (31) is formed of gallium arsenide.

9. A semiconductor device according to claim 7, characterized in that the distance between said source layer (331) and said drain layer (332) is about 1.5 μm.

10. A semiconductor device according to claim 7, characterized in that the distance between said gate electrode (35) and said drain layer (332) is about 0.7 μm.

11. A semiconductor device according to claim 7, characterized in that said gate electrode (35) is about 0.5 μm in length and about 300 μm in width.

12. A semiconductor device according to claim 7, characterized in that said gate electrode (35) is formed by an electron beam direct drawing method.

F I G. 1

F I G. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IEEE TRANSACTIONS ON ELECTRON DEVICES, vol. ED-30, no. 10, October 1983, pages 1395-1401, IEEE, New York, US; J. NULMAN et al.: "Fabrication and Analysis of 1/2 um Silicon Logic MESFET's" * Abstract; figure 1; paragraph 2; table 1 * --- | 1,6,7, 12 | H 01 L 29/10<br>H 01 L 29/60<br>H 01 L 29/812 |
| X | ELECTRONICS LETTERS, vol. 23, no. 20, 24th September 1987, pages 1073-1075, Stevenage, Herts, GB; A.E. GEISSBERGER et al.: "Refractory self-aligned gate technology for GaAs microwave FETs and MMICs" * Whole document * | 1-3,7-9 | |
| Y | IDEM --- | 1-5,7,8 ,10 | |
| Y | EP-A-0 275 905  (INTERNATIONAL STANDARD ELECTRIC) * Abstract; figures 1-5; column 3, lines 41-53 * --- | 1-5,7,8 ,10 | TECHNICAL FIELDS SEARCHED (Int. Cl.5)<br><br>H 01 L |
| A | IEEE TRAN. ON ELECTRON DEVICES, vol. 24, no. 8, August 1977, pages 1129-1131, New York, US; KEIICHI OHATA et al.: "Improved noise performance of GaAs MESFET's with selectively ion-implanted n+ source regions" * Paragraph IV * --- | 1-3,5 | |

-/-

The present search report has been drawn up for all claims

| Place of search | Date of completion of the search | Examiner |
|---|---|---|
| THE HAGUE | 22-01-1990 | MIMOUN B.J. |

EPO FORM 1503 03.82 (P0401)

European Patent
Office

EUROPEAN SEARCH REPORT

Application Number

EP  89 11 7517

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | ELECTRONICS LETTERS, vol. 23, no. 16, 30th July 1987, pages 844-845, Stevenage, Herts, GB; W.L. JONES et al.: "Very low-noise HEMTs using a 0.2 mum T-gate" * Whole document * | 1,2,6,7 ,8,12 | |

TECHNICAL FIELDS
SEARCHED (Int. Cl.5)

The present search report has been drawn up for all claims

| Place of search | Date of completion of the search | Examiner |
|---|---|---|
| THE HAGUE | 22-01-1990 | MIMOUN B.J. |

EPO FORM 1503 03.82 (P0401)